# FASCICULE DE BREVET EUROPEEN

(11) **EP 2 844 485 B1**
(45) Date de publication et mention de la délivrance du brevet: **05.04.2017**
(21) Numéro de dépôt: 13719828.9
(22) Date de dépôt: 26.04.2013
(51) Int. Cl.: B41J 2/14

(54) **MATRICE DE DEPOT D'AU MOINS UN FLUIDE CONDUCTEUR SUR UN SUBSTRAT, AINSI QUE DISPOSITIF COMPRENANT CETTE MATRICE ET PROCEDE DE DEPOT**
DÜSE ZUM AUFTRAGEN VON MINDESTENS EINER LEITENDEN FLÜSSIGKEIT AUF EIN SUBSTRAT UND VORRICHTUNG MIT SOLCH EINER MATRIX SOWIE AUFTRAGUNGSVERFAHREN
DIE FOR DEPOSITING AT LEAST ONE CONDUCTIVE FLUID ONTO A SUBSTRATE, AND DEVICE INCLUDING SUCH A MATRIX AND DEPOSITION METHOD

(30) Priorité: 30.04.2012 FR 1201262
(43) Date de publication de la demande: 11.03.2015
(73) Titulaire: Total Marketing Services, 92800 Puteaux (FR)
(72) Inventeur: JAFFRENNOU, Périne, CA 94041 (US); LOMBARDET, Benoît, F-38080 Saint Alban De La Roche (FR)
(74) Mandataire: Croonenbroek, Thomas Jakob
(86) Numéro de dépôt international: PCT/EP2013/058814
(87) Numéro de publication internationale: WO 2013/164284

(56) Documents cités:
- DE-A1-102009 059 042
- US-A- 4 312 009
- US-A- 5 713 673
- US-A- 5 745 128
- US-A1- 2004 032 459

## Description

L'invention concerne une matrice de dépôt d'au moins un fluide conducteur sur un substrat, ainsi qu'un dispositif comprenant cette matrice de dépôt et un procédé de dépôt.

L'invention s'applique plus particulièrement à la réalisation de métallisations et à la formation de contacts métalliques notamment dans le domaine des cellules photovoltaïques ou des interconnexions entre panneaux photovoltaïques.

Parmi les méthodes de métallisation actuellement existantes pour les cellules solaires pour réaliser des contacts localisés, on connaît par exemple les méthodes de sérigraphie ou par dépôt laser (également connue sous le nom « plating » en anglais).

La méthode majoritairement utilisée dans la production des cellules photovoltaïques pour réaliser des contacts métalliques est la sérigraphie.

Cette méthode consiste à déposer de l'Ag ou de l'Al par pression d'une pâte métallique à base d'Ag ou d'Al à travers un écran structuré. Malgré un coût peu élevé et un débit élevé de production, les inconvénients sont nombreux : cette méthode consomme une grande quantité de pâte (dépôt d'une épaisseur minimum de 10 µm et dépôt résiduel sur l'écran). De plus, cette méthode nécessite un contact avec le substrat combiné à une pression mécanique, ce qui augmente le risque de casse et ce qui empêche toute utilisation sur des substrats fins. Enfin, la largeur des lignes de métallisation est limitée par la taille des ouvertures de l'écran (∼100 µm minimum), et pour éviter une perte résistive importante, il peut être nécessaire de réaliser ces contacts métalliques par plusieurs passages.

Une autre méthode connue réalise ces contacts métalliques par un jet d'aérosol.

Lors du dépôt, du métal est déposé sous forme de gouttelettes (dit « spray » en anglais). La tête à partir de laquelle le métal, initialement sous forme d'encre, est éjecté sous forme de gouttelettes, peut être déplacée le long du substrat pour réaliser tout type de structure/motif pour réaliser des contacts localisés. Les pistes métalliques réalisées présentent une largeur de ligne fine (∼50 µm) et la consommation de métal est assez faible.

Cependant, le dépôt du métal étant réalisé à partir d'une seule tête, le débit et la vitesse de réalisation des contacts métalliques ne sont pas actuellement suffisants pour être implémentés dans un processus de production industrielle.

Par ailleurs, un point critique de cette méthode concerne l'alignement et le déplacement entre la tête éjectant le spray métallique et le substrat. En effet, cet alignement et le déplacement de la tête d'éjection doit être réalisé avec une grande précision (l'erreur sur le déplacement de la tête doit être faible par rapport à la taille des lignes de métallisation) pour ne pas réduire le rendement des cellules photovoltaïques. Or, un tel alignement nécessite des moyens techniques coûteux et demande un temps assez important ce qui réduit d'autant la cadence de production des cellules photovoltaïques.

Encore une autre approche proposée est connue sous le nom « contacts recuits par laser » (« Laser Fired Contact » en anglais) et décrit dans le document WO0060674.

Cette méthode permet de réaliser des contacts localisés pour une cellule solaire. Le substrat est d'abord métallisé pleine plaque puis un faisceau laser est focalisé en des points précis pour chauffer localement cette surface métallisée, afin de réaliser le contact à base d'alliage Al-Si. Le déplacement du faisceau laser permet de réaliser tout type de structure/motif. La qualité du contact et la non-dégradation du silicium peuvent être maîtrisés par l'utilisation de paramètres laser bien choisis. Ce procédé étant réalisé à partir d'une métallisation pleine plaque ne peut pas être utilisé pour des architectures de cellules à contact arrière (« Back Contact » en anglais).

Enfin, les sociétés BASF, SCHMID et Aurentum ont développé une machine de transfert d'encre par laser (en anglais « Laser Transfer Printing ») et des encres spécifiques, par exemple d'argent ou d'aluminium, commercialisées sous le nom Cyposol™L à base d'eau pour réaliser des contacts localisés pour les cellules solaires. Selon ce principe, un ruban défilant est enduit d'une encre visqueuse contenant le métal à déposer sur le substrat, la plaquette de semi-conducteur. Ce ruban défile au-dessus du substrat et un rayon laser est dirigé sur le ruban sur la face opposée à celle au regard du substrat, ce qui a pour conséquence d'éjecter l'encre par l'action du faisceau laser sur le substrat pour réaliser un contact métallique.

La viscosité de ces encres est telle que, par capillarité, l'encre reste collée sur le ruban dans les conditions standards et est éjectée lors de l'action du laser pour être déposée sur le substrat.

Ce procédé est continu : au cours du procédé, la viscosité de l'encre est contrôlée et ajustée et le ruban défile en continu. Ce ruban est transparent à la longueur d'onde du laser utilisé pour éjecter le métal.

Ce procédé est basé sur le principe du « Laser-Induced Forward

Transfer » (LIFT) (c'est-à-dire le transfert avant induit par laser en français), principalement utilisé en biologie, et consistant à éjecter par l'action d'un laser tout matériau visqueux déposé sur un support.

Selon ces sociétés des lignes de métallisation de diamètre inférieur à 60 µm peuvent être réalisées (voir par exemple *"*30µm wide contacts on silicon cells by laser transfer T.C. Roder, E. Hoffman, J. R. Kohler, J. H. Werner - Hawaï conference IEEE 2010*).*

Toutefois, ce dernier procédé est également délicat quant aux exigences d'alignement du laser, de la précision du déplacement du faisceau laser etc, de sorte que son application industrielle paraît complexe.

Dans le domaine des appareils d'impression par transfert d'encre, le document US 5 745 128 décrit un dispositif d'impression comprenant une matrice de transfert pour transférer de l'encre sur du papier en utilisant l'effet de viscosité. Toutefois, l'encre utilisée dans ce dispositif n'est pas conductrice et le dispositif n'est nullement utilisé pour réaliser des pistes conductrices sur un substrat comme dans la présente invention.

La présente invention vise à proposer un dispositif et un procédé plus simple et moins onéreux permettant de réaliser des contacts métalliques fins sur un substrat, en particulier pour réaliser des contacts métalliques de cellules photovoltaïques.

A cet effet, l'invention a pour objet une matrice de dépôt d'un fluide conducteur sur un substrat comprenant une structure de support d'au moins un fluide qui est conducteur et présente une viscosité sensible au rayonnement d'une source de lumière pour le dépôt dudit fluide sur un substrat afin de former des contacts ou pistes conducteurs sur le substrat,
dans laquelle que la structure de support comprend au moins un réservoir dudit fluide conducteur dont une paroi de fond est destinée à être en vis-à-vis dudit substrat lors du dépôt et en ce que ladite paroi de fond présente des perforations permettant l'écoulement dudit fluide conducteur sur le substrat lorsque ledit fluide est soumis au rayonnement de ladite source de lumière, les perforations étant pratiquées selon un motif du fluide à déposer sur le substrat, caractérisée en ce que la matrice de dépôt comporte en outre une plaque optique présentant un motif perméable au rayonnement de ladite source de lumière, la plaque optique étant imperméable au rayonnement de ladite source de lumière en dehors dudit motif, le motif perméable au rayonnement de ladite source de lumière de ladite plaque optique correspondant à un motif recouvrant le motif des perforations de ladite structure de support.

Ainsi, on peut arriver à une vitesse de dépôt semblable à celle de la sérigraphie tout en ayant une bonne conductivité des contacts métalliques. De plus, on obtient des contacts métalliques plus fins, ceci de manière reproductible.

En outre, grâce à la présence de la plaque optique comprenant des motifs recouvrant le motif des perforations, il est possible de contrôler le rayonnement lumineux activant le fluide conducteur. En particulier, la plaque optique permet une structuration du rayonnement lumineux (« patterning » en langue anglaise) qui active le fluide conducteur. Par exemple, la plaque optique peut être revêtue d'un revêtement filtrant (notamment sous la forme de filtres optiques) au niveau du motif perméable au rayonnement de ladite source de lumière. En utilisant un revêtement filtrant qui varie selon les différentes zones du motif perméable de la plaque optique, il est donc possible d'adapter les caractéristiques du rayonnement lumineux reçu par le fluide conducteur. Cela permet notamment d'utiliser le même dispositif de dépôt avec plusieurs types de fluides conducteurs (dans plusieurs réservoirs de fluides conducteurs) sans modifier la source lumineuse elle-même (puisque l'on adapte caractéristiques du rayonnement lumineux reçu par le fluide conducteur grâce aux caractéristiques du motif perméable de la plaque optique). Selon l'invention, l'utilisation de la plaque optique comprenant des motifs recouvrant le motif des perforations permet donc d'améliorer le contrôle de l'activation du fluide conducteur, tout en garantissant un bon alignement de la source lumineuse.

Selon un mode de réalisation de l'invention, la plaque optique forme la partie supérieure de ladite structure de support de façon à obtenir un réservoir fermé. Ce mode de réalisation a l'avantage de fournir un dispositif intégré dans lequel la plaque optique est directement intégrée dans le réservoir.

Selon un autre mode de réalisation de l'invention, la plaque optique est disposée au-dessus de ladite structure de support. En d'autres termes, la plaque optique ne ferme pas la structure de support et elle constitue une pièce distincte de la structure de support. Dans ce cas, les réservoirs de la structure de support peuvent être ouverts par le haut (ou perméables au rayonnement lumineux). Grâce à ce mode de réalisation, il est possible de garder la plaque optique et la source de lumière fixes l'un par rapport à l'autre et d'amener différents réservoirs sous la plaque optique. En fonction du motif de la plaque optique recouvrant les motifs de perforations de la structure de support, il est donc possible de traiter différents types de fluides conducteurs avec le même ensemble constitué de la plaque optique et de la source de lumière.

Selon d'autres caractéristiques prises seules ou en combinaison :
Selon un aspect, la structure de support est réalisée en un matériau qui ne contamine pas l'encre conductrice.

Selon encore un autre aspect, la structure de support peut être réalisée en nitrure de bore BN, carbure de silicium SiC, en un matériau céramique, en quartz SiO₂, en nitrure de silicium SiN, ou en matière plastique.

Alternativement, la structure de support peut être réalisée en inox ou un alliage métallique.

Il est envisagé que les parois intérieures dudit au moins un réservoir sont par exemple revêtues d'une couche de protection.

Ainsi, les parois intérieures dudit au moins un réservoir peuvent être revêtues d'une couche dont l'angle de mouillabilité selon la loi de Young-Dupré est inférieur à 90°.

A titre d'exemple, les perforations présentent un diamètre entre 1µm et 500µm.

La plaque optique peut être réalisée réfléchissante ou absorbante en dehors du motif perméable au rayonnement de ladite source de lumière.

Selon un développement, la structure de support comporte au moins un premier réservoir et un second réservoir.

Selon un aspect, le premier et le second réservoirs sont remplis d'un fluide conducteur différent.

Selon un autre aspect, au moins un des premier et second réservoirs est vide pour un traitement d'ablation, de dopage ou de recuit par rayonnement de ladite source de lumière.

On peut prévoir que chaque réservoir comporte une alimentation en continue du fluide conducteur et une évacuation du surplus de fluide conducteur.

Le fluide conducteur est par exemple une encre comprenant de l'argent, du nickel, du cuivre et / ou de l'aluminium à base d'eau ou autre solvant.

L'invention concerne également un dispositif de dépôt d'au moins une matière sur un substrat caractérisé en ce qu'il comprend une source de lumière et une matrice de dépôt tel que défini ci-dessus.

Ce dispositif peut comprendre des moyens optiques pour focaliser un faisceau lumineux de ladite source au niveau de la plaque optique.

Selon un autre aspect le dispositif comprend des moyens optiques pour obtenir un faisceau lumineux parallèle de ladite source au niveau de la plaque optique.
Selon encore un autre aspect, ladite source de lumière est choisie dans le groupe formé par un laser, une diode électroluminescente, une lampe.
L'invention concerne en outre un procédé de dépôt sur un substrat d'au moins un fluide qui contient des particules/un matériau conductrices/eurs et présente une viscosité sensible au rayonnement d'une source de lumière afin de former des contacts ou pistes conducteurs sur le substrat, caractérisé en ce que
   - on positionne au-dessus du substrat une matrice de dépôt tel que défini ci-dessus,
   - on soumet le fluide conducteur contenu dans au moins un réservoir de ladite structure de support au rayonnement d'une source de lumière au travers d'une plaque optique interposée de manière à fluidifier localement ledit fluide conducteur de manière que celui-ci s'écoule à travers des perforations ménagées dans la paroi de fond de la structure de support et se dépose selon un motif prédéfini.
Ce procédé de formation de contacts ou pistes conducteurs sur un substrat est très précis puisque les problèmes d'alignement de l'état de la technique sont résolus, notamment grâce au fait que les perforations sont pratiquées selon un motif du fluide à déposer sur le substrat. En outre, la plaque optique permet une structuration du rayonnement lumineux qui active le fluide conducteur.
Selon un aspect ladite source de lumière est un laser et on balaie ladite plaque optique avec le faisceau lumineux.
On envisage selon un mode de réalisation que l'on éclaire toute la surface de ladite plaque optique simultanément.

D'autres avantages et caractéristiques apparaîtront à la lecture de la description des figures suivantes, parmi lesquelles :
- la figure 1 montre un schéma d'un dispositif de dépôt d'au moins une matière sur un substrat,
- la figure 2 montre un schéma plus en détail d'une matrice de dépôt selon un mode de réalisation,
- la figure 3 montre le schéma de la figure 2 selon une coupe transversale selon la ligne II-II,
- la figure 3a montre un schéma de principe en relation avec la figure 3,
- la figure 4 montre une vue de dessous d'un exemple de la structure de support de la figure 2,
- la figure 5 montre une vue de dessus d'un exemple de la plaque optique de la figure 2,
- la figure 6 est le même schéma que celui de figure 2 montrant un exemple de balayage d'un faisceau laser, et
- la figure 7 montre un schéma du dispositif de dépôt selon un autre mode de réalisation.

Sur toutes les figures les mêmes références se rapportent aux mêmes éléments.

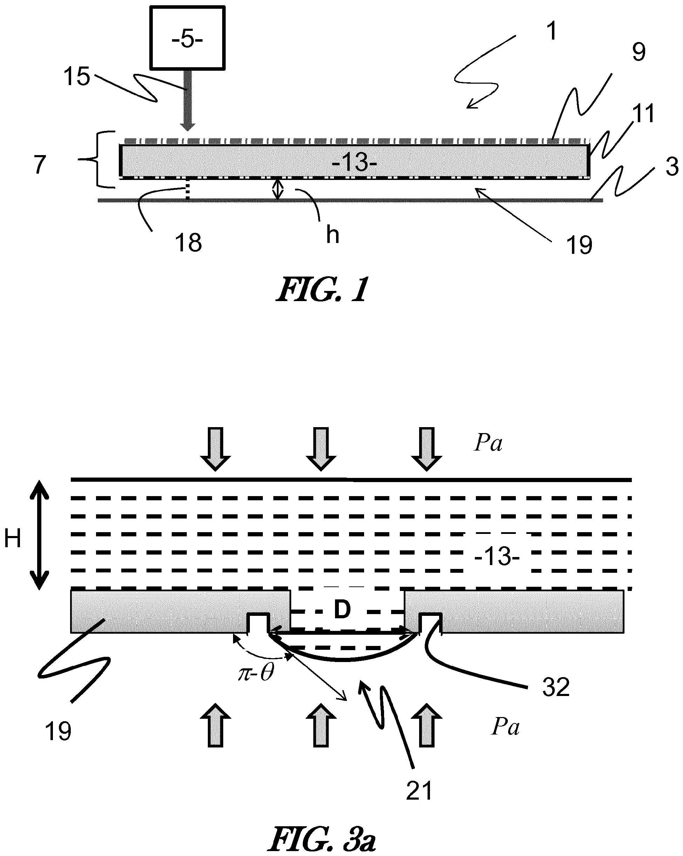

Sur la figure 1 est représenté un schéma d'un dispositif 1 de dépôt d'au moins une matière sur un substrat 3 pour réaliser des contacts métalliques, par exemple dans le cadre de la production de cellules photovoltaïques.

Ce dispositif comprend une source de lumière 5 et une matrice de dépôt 7 formée sur l'exemple de réalisation de la figure 1 d'une part d'une plaque optique 9 et d'autre part d'une structure de support 11 d'au moins un fluide 13 qui est conducteur et présente une viscosité sensible au rayonnement 15 de la source de lumière 5 pour le dépôt dudit fluide 13 sur le substrat 3 afin de former des contacts ou pistes conducteurs sur le substrat 3.

Le fluide conducteur 13 présentant une viscosité sensible au rayonnement est par exemple une encre spécifique, par exemple d'argent, de nickel, de cuivre ou d'aluminium, à base d'eau ou autre solvant pour réaliser des contacts localisés pour les cellules solaires.

Le fluide 13 peut être conducteur par le fait qu'il est chargé en particules conductrices en métal.

Par fluide dont la viscosité est sensible au rayonnement de la source de lumière 5, on entend que la viscosité du fluide diminue localement au niveau de l'impact du rayonnement 15 de la source lumineuse 5. Ceci peut être dû à un effet photosensible, c'est-à-dire dépendant surtout de la longueur d'onde de la lumière ou à un effet thermosensible, c'est-à-dire que le rayonnement 15 provoque localement un échauffement du fluide conducteur 13 rendant ce dernier moins visqueux.

Bien entendu, tout fluide conducteur ou fluide comportant des particules conductrices présentant des propriétés similaires peut également être choisi.

La source de lumière 5 est par exemple un laser, une diode électroluminescente ou une lampe.

Ce qui est important, c'est que la longueur d'onde et / ou l'intensité lumineuse de la source de lumière 5 sont choisies de façon pour que l'impact de la lumière de la source sur le fluide conducteur, par exemple une encre, modifie, notamment par effet photosensible ou effet thermosensible, la viscosité du fluide conducteur en le rendant moins visqueux.

Le laser ou la diode laser a pour avantage comme source lumineuse 5 d'émettre un rayonnement 15 à haute intensité et à une ou plusieurs longueurs d'onde bien définies, qui peut être facilement dirigé par rapport à la plaque optique 9 et la structure de support 11. Comme on le verra plus loin, le faisceau lumineux doit alors balayer la plaque optique 9 pour le dépôt de métal sur le substrat 3 ou balayer le support sans plaque optique.

En utilisant une diode électroluminescente, une matrice de diodes électroluminescentes ou une lampe, on peut éclairer la matrice de dépôt 7 formé du support avec la plaque optique 9 en même temps ce qui permet d'accélérer le processus de dépôt. En effet, on éclaire ainsi uniformément la matrice de dépôt 7 pendant une durée suffisante pour permettre l'écoulement et le dépôt du fluide conducteur 13 sur le substrat 3.

Bien entendu, on peut envisager en fonction de la source de lumière choisie d'utiliser des moyens optiques (non représentés), comme par exemple des lentilles pour focaliser un faisceau lumineux de ladite source au niveau de la plaque optique 11.

De façon similaire, en particulier avec un laser comme source de lumière 5, on peut utiliser des moyens optiques divergents (non représentés) pour obtenir un faisceau lumineux parallèle de ladite source 5 au niveau de la plaque optique 11, de sorte à éclairer celle - ci complètement.

Bien entendu, ces moyens optiques peuvent se composer de plusieurs lentilles, prismes ou autres éléments optiques pour diriger le rayonnement lumineux 15 de la source 5 vers la matrice de dépôt 7.

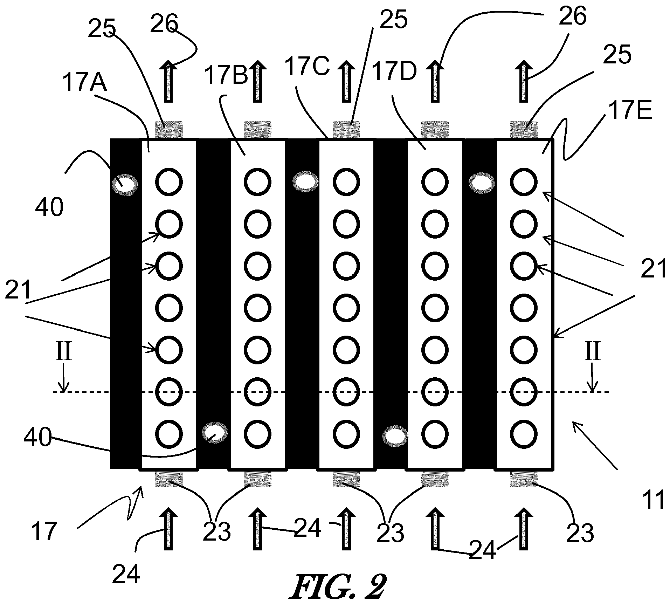

Par la suite, on décrira plus en détail la matrice de dépôt 7 au regard des figures 2 à 5.

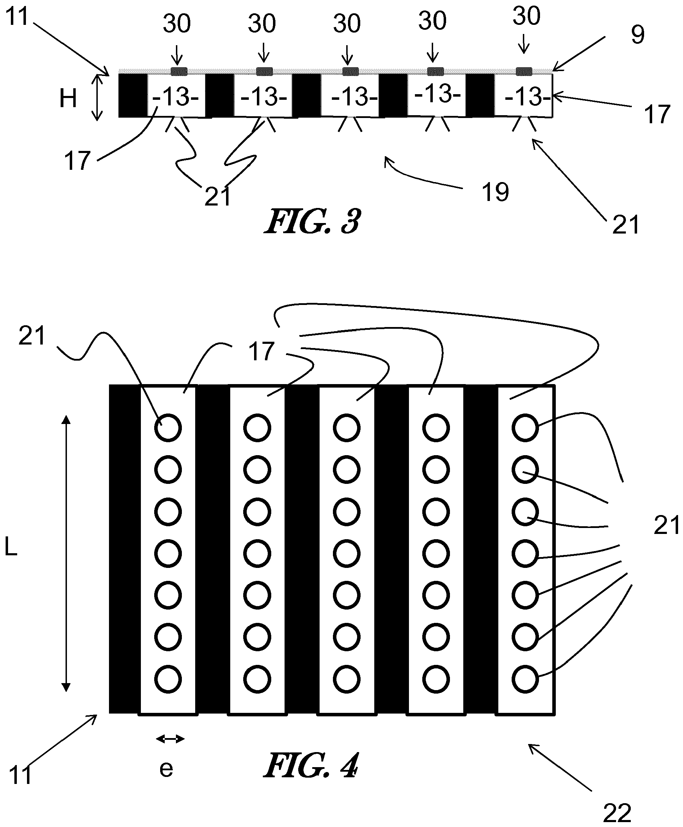

Comme on le voit sur les figures 2 et 3, la structure de support 11 comprend au moins un réservoir 17 dudit fluide conducteur 13, cinq réservoirs 17 (respectivement numérotées 17A, 17B, 17C, 17D et 17E) dans le présent exemple.

La paroi de fond 19 de chaque réservoir 17 est destinée à être en vis-à-vis dudit substrat 3 lors du dépôt et présente des perforations 21 permettant l'écoulement 18 (montré en pointillé sur la figure 1) dudit fluide conducteur 13 sur le substrat 3 lorsque ledit fluide 13 est soumis au rayonnement de ladite source de lumière 5.

Comme on peut le voir sur la figure 4 montrant la face inférieure de la structure de support 11, les perforations 21 sont pratiquées selon un motif 22 du fluide à déposer sur le substrat 3.

Dans le présent exemple, le motif 22 est composé de cinq rangées de perforations 21 alignées et parallèles. Bien entendu, toute sorte de motif est envisageable en fonction des besoins des contacts métalliques à réaliser. Le motif 22 correspond donc à des contacts électriques à réaliser et/ ou à des pistes conductrices reliant ces contacts électriques pour collecter le courant fourni par les cellules photovoltaïques d'un panneau photovoltaïque.

Selon une première variante, la structure de support est réalisée par exemple en nitrure de bore BN, en carbure de silicium SiC, en quartz SiO₂, en nitrure de silicium SiN, en un matériau céramique ou encore en matière plastique résistant à la chaleur.

Selon une seconde variante, la structure de support est réalisée en inox ou en alliage métallique.

Dans le choix du matériau de la structure de support, on veille à ce que ce matériau soit un matériau non contaminant de sorte qu'il ne puisse pas contaminer le fluide conducteur 13 à déposer sur le substrat. Par non contaminant, on entend en particulier le fait que l'encre ne soit pas polluée (pas chargée par des résidus du matériau de la structure de support), et qu'il n'y ait pas d'interaction / réaction entre le matériau de support et l'encre conductrice.

Pour renforcer la protection du fluide conducteur 13, on envisage dans certains cas que les parois intérieures des réservoirs 17 soient revêtues d'une couche de protection.

Pour améliorer les propriétés de mouillabilité, on envisage également que les parois intérieures de ladite structure de support sont revêtues d'une couche dont l'angle de mouillabilité θ selon la loi de Young-Dupré est inférieur à 90°. Cette couche peut également avoir la fonction de couche de protection. La couche sera réalisée par exemple en nitrure de bore BN, en carbure de silicium SiC, en quartz SiO₂, en nitrure de silicium SiN, en un matériau céramique ou encore en matière plastique résistant à la chaleur. En ce qui concerne les perforations 21, celles-ci peuvent présenter un diamètre compris entre 1 et 500µm. Ce diamètre dépend essentiellement d'une part de la taille / largeur des contacts métalliques à réaliser et des paramètres de viscosité avec et sans rayonnement du fluide conducteur 13. En effet, sans rayonnement, le diamètre doit être assez petit pour contenir le fluide conducteur 13 par capillarité dans le réservoir 17 et permettre son écoulement 18 et dépôt sur le substrat 3 lorsque le fluide conducteur 13 est soumis à ce rayonnement 15.

La figure 3a montre selon une vue agrandie le réservoir 17 rempli du fluide conducteur 13 au niveau d'une ouverture 21.

La tension superficielle du fluide conducteur 13 permet de former sous chaque ouverture un ménisque convexe stable et permet que le fluide conducteur 13 reste dans le réservoir. La condition de stabilité du ménisque déterminée par la loi de Young-Laplace est H*<****σ.sinθ*/*(ρgD*)**, où H est la hauteur de fluide, σ la tension superficielle, ***θ*** l'angle de mouillage, ***ρ*** la masse volumique du fluide, g l'accélération de la pesanteur et **D** le diamètre du ménisque (voir figure 3a).

Selon une variante facultative (représenté sur la figure 3a), on peut prévoir une gorge circonférentielle 32 autour de chaque ouverture 21 pour limiter l'extension du ménisque et améliorer sa stabilité.

Le diamètre des ouvertures et la distance entre les perforations ou ouvertures 21 doivent être choisi en fonction du design du dépôt.

Par exemple, des ouvertures 21 très rapprochées et un fluide conducteur 13 aux propriétés de viscosité telle que son étalement sur le substrat est contrôlé peuvent permettre de faire un dépôt d'une ligne continue sur le substrat 3. Par exemple dans le cas d'une métallisation de face avant de cellules solaires en silicium, les lignes de métallisation ont un diamètre entre 10 et 150 µm. Les tailles des ouvertures 21 sont choisies de telle manière que la substance est déposée environ sur cette largeur et que, lorsque la source optique 5 balaie la structure de support 11, le fluide conducteur 13 se dépose et s'étale de manière homogène formant ainsi une ligne continue.

Par exemple, les ouvertures 21 peuvent être espacées de telle manière que le dépôt puisse être localisé pour des contacts en face arrière de cellule type PERC (diamètre du contact une fois déposé entre 10 et 100µm et espacement entre les contacts entre 400 µm et 1 mm).

Comme précisé plus haut, un autre paramètre à prendre en considération est aussi la hauteur H du fluide conducteur 13 dans le réservoir 17 comprise entre par exemple 300µm à 1mm. Il est seulement nécessaire, qu'un film de fluide conducteur 13 soit sur la paroi de fond 19.

Il s'est avéré très avantageux que chaque réservoir comporte une alimentation 23 en continu (indiqué par les flèches 24) du fluide conducteur 13 et une évacuation 25 du surplus (indiqué par les flèches 26) de fluide conducteur 13.

Ainsi, la structure de support 11 peut être alimentée en continu, ce qui est très bien adapté pour un processus industriel en continu pour la réalisation de contacts métalliques sur un substrat, en particulier dans la fabrication de cellules photovoltaïques.

Bien entendu, il peut s'agir d'une boucle et le fluide conducteur 13 évacué est à nouveau réinjecté dans les réservoirs 17.

Ainsi, le dispositif 1 est très économe en quantité de fluide conducteur 13 utilisé.

Selon le mode de réalisation de la figure 2, on a plusieurs réservoirs 17A à 17E allongés.

Selon un autre mode de réalisation non représenté, on peut avoir un seul réservoir 17 ayant la dimension de tous les réservoirs 17A à 17E pris ensemble.

Dans le mode de réalisation de la figure 2, tous les réservoirs 17A à 17E sont remplis du même fluide conducteur 13.

Selon un autre développement et selon les besoins de dépôt de métal, un premier réservoir 17A est rempli d'un premier fluide conducteur et le second réservoir 17B est rempli d'un second fluide conducteur différent. On peut par exemple ainsi alterner les fluides conducteurs. Même trois ou plus de fluides conducteurs différents sont envisageable sans sortir du cadre de la présente invention.

Selon encore un autre développement, on peut prévoir des réservoirs vides parmi les réservoirs remplis. Dans ce cas, le faisceau lumineux de la source de lumière 5 peut passer à travers les orifices 21 et atteindre directement le substrat 3 pour par exemple un traitement d'ablation ou de recuit par rayonnement de ladite source de lumière 5. Il peut aussi s'agir par exemple d'un traitement spécifique local par laser ou un dopage par traitement laser.

Après la description de la structure de support 11, on se tourne vers la plaque optique 9.

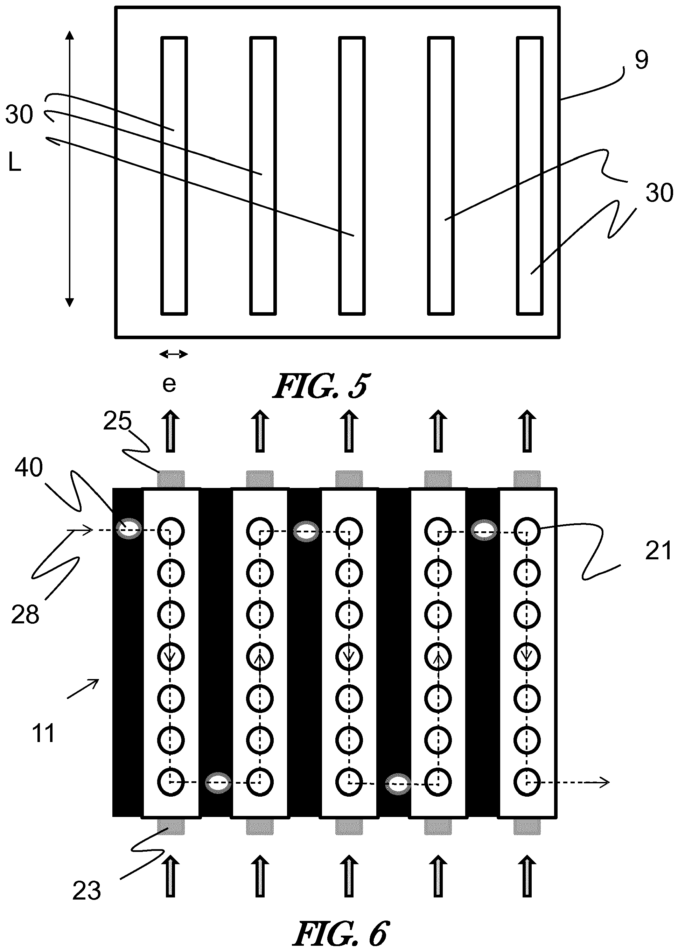

Un exemple d'une plaque optique 9 est représenté sur la figure 5. Celle-ci peut former une paroi supérieure de la structure de support 11 ou être posée sur celle-ci (voir figures 1 et 3). Dans ce dernier cas, il est nécessaire que le matériau de la structure de support 11, au moins en ce qui concerne cette paroi supérieure, soit optiquement transparent pour le rayonnement de la source de lumière 5.

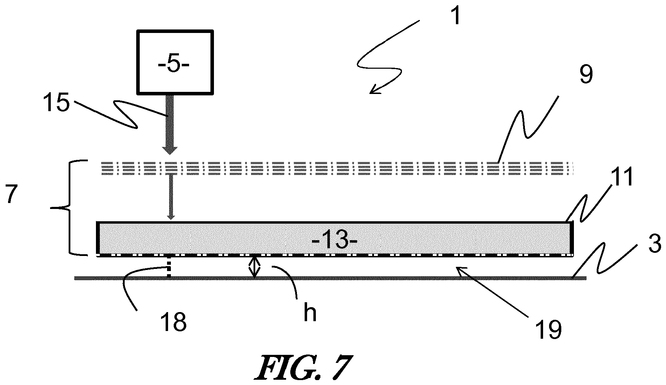

Selon un autre mode de réalisation représenté à la figure 7, la plaque optique 9 est disposée à une distance constante au-dessus de ladite structure de support. Dans ce cas, les réservoirs 17 de la structure de support peuvent être ouverts par le haut.

Dans ce mode de réalisation, on peut amener différents réservoirs 17 sous la plaque optique 9. En fonction du motif de la plaque optique recouvrant les motifs de perforations de la structure de support, il est donc possible de traiter différents types de fluides conducteurs avec le même ensemble constitué de la plaque optique et de la source de lumière.

La plaque 9 présente un motif 30 perméable au rayonnement de ladite source de lumière 5 et la plaque 9 est imperméable au rayonnement de ladite source de lumière en dehors dudit motif 30. Le motif 30 correspond à un motif recouvrant le motif 22 des perforations.

Par imperméable au rayonnement de la source de lumière 5, on entend que ce rayonnement est soit absorbé soit réfléchi.

Par perméable au rayonnement, on entend que la lumière de la source 5 est transmise majoritairement à travers la plaque optique 9.

Le motif 30 de la plaque optique 9 recouvre le motif 22 des perforations 21.

Ainsi, comme on le voit sur la figure 5, le motif 30 est formé de cinq bandes dont la largeur e correspond au diamètre des performations 21 et la longueur L correspond à la distance entre les trous d'extrémités.

Cependant, en particulier dans le cas où la plaque optique 9 est disposée à distance de la structure de support 11, il faut tenir compte de la projection du rayonnement de la source au travers la plaque optique 9 au niveau des perforations 21 pour atteindre à ce niveau une intensité suffisante pour réduire la viscosité du fluide conducteur 13 pour permettre son écoulement 18 et son dépôt sur le substrat 3.

Selon d'autres développements, on peut prévoir que les motifs 22 et 30 sont identiques, en particulier si la source de lumière 5 est un laser.

Selon une première variante, la plaque optique est donc réalisée réfléchissante ou absorbante en dehors du motif 30 perméable au rayonnement de ladite source de lumière.

Selon une seconde variante, la plaque optique est revêtue d'un revêtement filtrant au niveau un motif 30 perméable au rayonnement de ladite source de lumière 5. Il peut par exemple s'agir de filtres coupe-bande (« notch filter » en anglais) au niveau du motif 30 perméable au rayonnement de ladite source de lumière. Ces filtres peuvent par exemple être différents, c'est-à-dire posséder des bandes de coupe différentes, à divers emplacements de la plaque optique 9 pour tenir compte de traitements locaux spécifiques en fonction de la localisation sur le substrat 3, par exemple pour fluidifier un fluide conducteur 13 pour son dépôt sur le substrat 3, ou pour un traitement du métal déposé sur le substrat. Si on a par exemple plusieurs réservoirs 17 avec des fluides conducteurs différents, voir un réservoir 17 sans fluide conducteur, le motif 30 en tient compte par la réponse spectrale et/ou spatiale des filtres coupe-bande au-dessus de chaque réservoir.

En prévoyant un motif 30 perméable dans la plaque optique 9 qui correspond à un motif recouvrant le motif 22 des perforations 21 de ladite structure de support, on peut s'affranchir des problèmes d'alignement du laser tout en permettant une précision de dépôt importante. Ceci permet d'ouvrir la voie à un procédé industriel à grande échelle qui est peu onéreux tout en assurant la précision de dépôt nécessaire en particulier en termes de tracé et d'épaisseurs de pistes conductrices, notamment dans le domaine photovoltaïque où des imprécisions peuvent conduire à une perte d'efficacité. En outre, la présence de la plaque optique comprenant des motifs recouvrant le motif des perforations, il est possible de contrôler le rayonnement lumineux activant le fluide conducteur

De plus, selon le motif de la plaque optique 9 recouvrant le motif 22 des perforations 21 de ladite structure de support, le fluide conducteur 13 peut être guidé / maintenu à la pression souhaitée dans le réservoir, ce qui permet une plus grande liberté dans la composition d'encre et sa viscosité à température ambiante ainsi que l'énergie de la source de lumière 5 utilisée pour diminuer la viscosité du fluide conducteur 13.

Le dispositif 1 de dépôt fonctionne de la manière suivante :
On positionne au-dessus du substrat 3 la matrice de dépôt 7 telle que décrite ci-dessus. L'alignement du substrat 3 de la matrice de dépôt 7 peut se faire par des moyens conventionnels.

La distance entre la structure de support 11 et le substrat 3 doit être optimisée de telle manière que le fluide conducteur 13 se dépose sur une surface prédéfinie et de manière contrôlée. Lors du dépôt, la structure de support 11 est placée à une hauteur supérieure à l'épaisseur de la couche à déposer afin qu'il n'y ait pas de contact. Par exemple, la structure de support 11 peut être disposée à une distance de l'ordre d'une dizaines de micromètres au-dessus de l'épaisseur fini du contact métallique sur le substrat 3.

La structure de support 11 peut être maintenue par des moyens électromécaniques de déplacement (par exemple une platine de déplacement mécanique ou une platine piézoélectrique), en particulier pour contrôler la hauteur h du support par rapport au substrat 3, mais aussi pour son déplacement en x et y.

Puis, on soumet ladite plaque optique 9 au rayonnement de la source de lumière 5 de manière à fluidifier localement, par des rayons de lumière pénétrant jusqu'aux orifices 21, ledit fluide conducteur 13 de manière que celui-ci s'écoule à travers un orifice 21 ménagé dans la paroi de fond 19 et se dépose selon le motif 22 prédéfini.

A cet effet, comme on le voit sur la figure 6, on balaie ladite plaque optique avec le faisceau lumineux selon le chemin en pointillé 28.

Pour maîtriser la densité d'énergie incidente, des détecteurs d'intensité 40 peuvent être intégrés au niveau de la structure de support 11, de préférence de manière à se trouver sur le chemin de balayage du faisceau lumineux.

Bien entendu, selon la source de lumière 5, on peut aussi prévoir d'éclairer toute la surface de ladite plaque optique 9 simultanément.

On comprend donc que la présente invention permet la réalisation aisée et rapide de contacts métalliques sur un substrat, en particulier pour la production de cellules photovoltaïques.

## Revendications

1. Matrice de dépôt d'un fluide conducteur sur un substrat comprenant une structure de support (11) d'au moins un fluide (13) qui est conducteur et présente une viscosité sensible au rayonnement d'une source de lumière (5) pour le dépôt dudit fluide (13) sur un substrat (3) afin de former des contacts ou pistes conducteurs sur le substrat (3),
dans laquelle la structure de support (11) comprend au moins un réservoir (17) dudit fluide conducteur dont une paroi de fond (19) est destinée à être en vis-à-vis dudit substrat (3) lors du dépôt et dans laquelle ladite paroi de fond (19) présente des perforations (21) permettant l'écoulement (18) dudit fluide conducteur (13) sur le substrat (3) lorsque ledit fluide (13) est soumis au rayonnement (15) de ladite source de lumière (5), les perforations (21) étant pratiquées selon un motif (22) du fluide à déposer sur le substrat (3), **caractérisée en ce qu'**elle comporte en outre une plaque optique (9) présentant un motif (30) perméable au rayonnement de ladite source de lumière (5), la plaque optique (9) étant imperméable au rayonnement de ladite source de lumière (5) en dehors dudit motif (30) et le motif (30) perméable au rayonnement de ladite source de lumière de ladite plaque optique (9) correspondant à un motif recouvrant le motif (22) des perforations de ladite structure de support.

2. Matrice de dépôt selon la revendication 1, **caractérisée en ce que** la structure de support (11) est ouverte par le haut.

3. Matrice de dépôt selon l'une quelconque des revendications 1 à 2, **caractérisée en ce que** la structure de support (11) est réalisée en nitrure de bore BN, carbure de silicium SiC, en un matériau céramique, en quartz SiO₂, en nitrure de silicium SiN, en matière plastique, en inox ou un alliage métallique.

4. Matrice de dépôt selon l'une quelconque des revendications 1 à 3, **caractérisée en ce que** les parois intérieures dudit au moins un réservoir (17) sont revêtues d'une couche de protection.

5. Matrice de dépôt selon l'une quelconque des revendications 1 à 4, **caractérisée en ce que** les parois intérieures dudit au moins un réservoir (17) sont revêtues d'une couche dont l'angle de mouillabilité selon la loi de Young-Dupré est inférieur à 90°.

6. Matrice de dépôt selon l'une quelconque des revendications 1 à 5, **caractérisée en ce que** les perforations (21) présentent un diamètre entre 1µm et 500µm.

7. Matrice de dépôt selon l'une quelconque des revendications 1 à 6, **caractérisée en ce que** la plaque optique (9) forme la paroi supérieure de ladite structure de support (11) de façon à obtenir un réservoir fermé.

8. Matrice de dépôt selon l'une quelconque des revendications 1 à 7, **caractérisée en ce que** la plaque optique (9) est réalisée réfléchissante ou absorbante en dehors du motif (30) perméable au rayonnement de ladite source de lumière.

9. Matrice de dépôt selon l'une quelconque des revendications 1 à 8, **caractérisée en ce que** la plaque optique (9) est revêtue d'un revêtement filtrant au niveau du motif (30) perméable au rayonnement de ladite source de lumière (5) et comporte notamment des filtres optiques.

10. Matrice de dépôt selon l'une quelconque des revendications précédentes, **caractérisée en ce que** la structure de support (11) comporte au moins un premier réservoir (17A) et un second réservoir (17B).

11. Matrice de dépôt selon la revendication 10, **caractérisée en ce qu'**au moins un des premier (17A) et second (17B) réservoirs est destiné à être utilisé vide pour un traitement d'ablation, de dopage ou de recuit par rayonnement de ladite source de lumière (5).

12. Matrice de dépôt selon l'une quelconque des revendications 1 à 11, **caractérisée en ce qu'**elle est destinée à être utilisée avec un fluide conducteur (13) qui est une encre comprenant de l'argent, du nickel, du cuivre et / ou de l'aluminium à base d'eau ou autre solvant.

13. Dispositif (1) de dépôt d'au moins une matière sur un substrat **caractérisé en ce qu'**il comprend une source de lumière (5) et une matrice de dépôt (7) selon l'une quelconque des revendications 1 à 12.

14. Dispositif selon la revendication 13, **caractérisé en ce qu'**il comprend des moyens optiques pour focaliser un faisceau lumineux de ladite source (5) au niveau de la plaque optique (9).

15. Procédé de dépôt sur un substrat (3) d'au moins un fluide (13) qui contient des particules/un matériau conductrices/eurs et présente une viscosité sensible au rayonnement d'une source de lumière (5) afin de former des contacts ou pistes conducteurs sur le substrat (3), **caractérisé en ce que**
- on positionne au-dessus du substrat (3) une matrice de dépôt (7) selon l'une quelconque des revendications 1 à 12,
- on soumet le fluide conducteur (13) contenu dans au moins un réservoir (17) de ladite structure de support (11) au rayonnement d'une source de lumière (5) au travers de la plaque optique (9) interposée de manière à fluidifier localement ledit fluide conducteur (13) de manière que celui-ci s'écoule à travers des perforations (21) ménagées dans la paroi de fond (19) de la structure de support (11) et se dépose selon un motif prédéfini.

## Patentansprüche

1. Matrize zum Ablagern eines leitenden Fluids auf einem Substrat, das eine Tragstruktur (11) aus wenigstens einem Fluid (13) aufweist, das ein Leiter ist und eine für die Strahlung einer Lichtquelle (5) empfindliche Viskosität aufweist, um das Fluid (13) auf einem Substrat (3) abzulagern, um auf dem Substrat (3) Kontakte oder Leiterbahnen zu bilden,
wobei die Tragstruktur (11) wenigstens einen Vorratsbehälter (17) für das leitende Fluid umfasst, wovon eine Bodenwand (19) dazu bestimmt ist, sich bei der Ablagerung gegenüber dem Substrat (3) zu befinden, und wobei die Bodenwand (19) Perforationen (21) aufweist, die das Ausfließen (18) des leitenden Fluids (13) auf das Substrat (3) ermöglichen, wenn das Fluid (13) der Strahlung (15) der Lichtquelle (5) ausgesetzt ist, wobei die Perforationen (21) gemäß einem Muster (22) des auf dem Substrat (3) abzulagernden Fluids ausgebildet sind, **dadurch gekennzeichnet, dass** sie außerdem eine optische Platte (9) umfasst, die ein für die Strahlung der Lichtquelle (5) durchlässiges Muster (30) aufweist, wobei die optische Platte (9) für die Strahlung der Lichtquelle (5) außerhalb des Musters (30) undurchlässig ist und wobei das für die Strahlung der Lichtquelle durchlässige Muster (30) der optischen Platte (9) einem Muster entspricht, das das Muster (22) der Perforationen der Tragstruktur abdeckt.

2. Ablagerungsmatrize nach Anspruch 1, **dadurch gekennzeichnet, dass** die Tragstruktur (11) nach oben offen ist.

3. Ablagerungsmatrize nach einem der Ansprüche 1 bis 2, **dadurch gekennzeichnet, dass** die Tragstruktur (11) aus Bornitrid BN, Siliciumcarbid SiC, einem Keramikmaterial, Quarz SiO₂, Siliciumnitrid SiN, Kunststoff, Edelstahl oder einer Metalllegierung hergestellt ist.

4. Ablagerungsmatrize nach einem der Ansprüche 1 bis 3, **dadurch gekennzeichnet, dass** die Innenwände des wenigstens einen Vorratsbehälters (17) mit einer Schutzschicht überzogen sind.

5. Ablagerungsmatrize nach einem der Ansprüche 1 bis 4, **dadurch gekennzeichnet, dass** die Innenwände des wenigstens einen Vorratsbehälters (17) mit einer Schicht überzogen sind, deren Benetzbarkeitswinkel gemäß dem Young-Dupre-Gesetz kleiner als 90° ist.

6. Ablagerungsmatrize nach einem der Ansprüche 1 bis 5, **dadurch gekennzeichnet, dass** die Perforationen (21) einen Durchmesser im Bereich von 1 µm bis 500 µm besitzen.

7. Ablagerungsmatrize nach einem der Ansprüche 1 bis 6, **dadurch gekennzeichnet, dass** die optische Platte (9) die obere Wand der Tragstruktur (11) bildet, derart, dass ein geschlossener Vorratsbehälter erhalten wird.

8. Ablagerungsmatrize nach einem der Ansprüche 1 bis 7, **dadurch gekennzeichnet, dass** die optische Platte (9) außerhalb des Musters (30), das für die Strahlung der Lichtquelle durchlässig ist, reflektierend oder absorbierend ausgeführt ist.

9. Ablagerungsmatrize nach einem der Ansprüche 1 bis 8, **dadurch gekennzeichnet, dass** die optische Platte (9) auf Höhe des für die Strahlung der Lichtquelle (5) durchlässigen Musters (30) mit einer Filterungsbeschichtung überzogen ist, die insbesondere optische Filter enthält.

10. Ablagerungsmatrize nach einem der vorhergehenden Ansprüche, **dadurch gekennzeichnet, dass** die Tragstruktur (11) wenigstens einen ersten Vorratsbehälter (17A) und einen zweiten Vorratsbehälter (17B) umfasst.

11. Ablagerungsmatrize nach Anspruch 10, **dadurch gekennzeichnet, dass** wenigstens ein der erste (17A) und der zweite (17B) Vorratsbehälter dazu bestimmt sind, für eine Ablations-, Dotierungs- oder Glühbearbeitung durch die Strahlung der Lichtquelle (5) leer verwendet zu werden.

12. Ablagerungsmatrize nach einem der Ansprüche 1 bis 11, **dadurch gekennzeichnet, dass** sie dazu bestimmt ist, mit einem leitenden Fluid (13) verwendet zu werden, das eine Tinte ist, die Silber, Nickel, Kupfer und/oder Aluminium auf der Basis von Wasser oder einem anderen Lösungsmittel enthält.

13. Vorrichtung (1) zum Ablagern wenigstens eines Materials auf einem Substrat, **dadurch gekennzeichnet, dass** sie eine Lichtquelle (5) und eine Ablagerungsmatrize (7) nach einem der Ansprüche 1 bis 12 umfasst.

14. Vorrichtung nach Anspruch 13, **dadurch gekennzeichnet, dass** sie optische Mittel umfasst, um ein Lichtstrahlenbündel der Quelle (5) auf Höhe der optischen Platte (9) zu fokussieren.

15. Verfahren zum Ablagern auf einem Substrat (3) wenigstens eines Fluids (13), das leitende Partikel/ein leitendes Material enthält und eine für die Strahlung einer Lichtquelle (5) empfindliche Viskosität aufweist, um auf dem Substrat (3) Kontakte oder Leiterbahnen zu bilden, **dadurch gekennzeichnet, dass**
- auf dem Substrat (3) eine Ablagerungsmatrize (7) nach einem der Ansprüche 1 bis 12 positioniert wird und
- das in wenigstens einem Vorratsbehälter (17) der Tragstruktur (11) enthaltene leitende Fluid (13) der Strahlung einer Lichtquelle (5) durch die eingefügte optische Platte (9) ausgesetzt wird, derart, dass das leitende Fluid (13) lokal fluidisiert wird, derart, dass es durch die in der Bodenwand (19) der Tragstruktur (11) ausgesparten Perforationen (21) ausfließt und sich in einem im Voraus definierten Muster ablagert.

## Claims

1. Matrix for depositing a conductive fluid on a substrate comprising a structure (11) for holding at least one fluid (13) that is conductive and has a viscosity sensitive to radiation from a light source (5) for depositing said fluid (13) on a substrate (3) in order to form conductive tracks or contacts on the substrate (3),
in which the holding structure (11) comprises at least one reservoir (17) for said conductive fluid a bottom wall (19) of which is intended to be placed facing said substrate (3) during the deposition and in which said bottom wall (19) contains perforations (21) allowing said conductive fluid (13) to flow (18) onto the substrate (3) when said fluid (13) is exposed to radiation (15) from said light source (5), the perforations (21) being produced according to a pattern (22) of the fluid to be deposited on the substrate (3), **characterized in that** it furthermore comprises an optical plate (9) having a pattern (30) permeable to radiation from said light source (5), the optical plate (9) being impermeable to radiation from said light source (5) beyond said pattern (30) and the pattern (30) permeable to radiation from said light source, of said optical plate (9) corresponding to a pattern covering the pattern (22) of the perforations in said holding structure.

2. Deposition matrix according to Claim 1, **characterized in that** the holding structure (11) is open-topped.

3. Deposition matrix according to either of Claims 1 and 2, **characterized in that** the holding structure (11) is made of boron nitride BN, silicon carbide SiC, of a ceramic material, of quartz SiO₂, of silicon nitride SiN, of plastic, of stainless steel or of a metal alloy.

4. Deposition matrix according to any one of Claims 1 to 3, **characterized in that** the internal walls of said at least one reservoir (17) are coated with a protective layer.

5. Deposition matrix according to any one of Claims 1 to 4, **characterized in that** the internal walls of said at least one reservoir (17) are coated with a layer the contact angle of which according to Young-Dupré's equation is lower than 90°.

6. Deposition matrix according to any one of Claims 1 to 5, **characterized in that** the perforations (21) have a diameter of between 1 µm and 500 µm.

7. Deposition matrix according to any one of Claims 1 to 6, **characterized in that** the optical plate (9) forms the upper wall of said holding structure (11) so as to obtain a closed reservoir.

8. Deposition matrix according to any one of Claims 1 to 9, **characterized in that** the optical plate (9) is reflective or absorbent beyond the pattern (30) permeable to radiation from said light source.

9. Deposition matrix according to any one of Claims 1 to 8, **characterized in that** the optical plate (9) is coated with a filtering coating at the level of the pattern (30) permeable to radiation from said light source (5) and in particular comprises optical filters.

10. Deposition matrix according to any one of the preceding claims, **characterized in that** the holding structure (11) comprises at least a first reservoir (17A) and a second reservoir (17B).

11. Deposition matrix according to Claim 10, **characterized in that** at least one of the first and second reservoirs (17A and 17B) is intended to be used empty in order to allow an ablation, doping or annealing treatment to be carried out using the radiation from said light source (5).

12. Deposition matrix according to any one of Claims 1 to 11, **characterized in that** it is intended to be used with a conductive fluid (13) that is an ink containing silver, nickel, copper and/or aluminum, based on water or another solvent.

13. Device (1) for depositing at least one material on a substrate, **characterized in that** it comprises a light source (5) and a deposition matrix (7) according to any one of Claims 1 to 12.

14. Device according to Claim 13, **characterized in that** it comprises optical means for focusing a light beam from said source (5) on the optical plate (9).

15. Process for depositing on a substrate (3) at least one fluid (13) that contains a conductive material/conductive particles and has a viscosity sensitive to radiation from a light source (5) in order to form conductive tracks or contacts on the substrate (3), **characterized in that**:
- a deposition matrix (7) according to any one of Claims 1 to 12 is positioned above the substrate (3); and
- the conductive fluid (13) contained in at least one reservoir (17) of said holding structure (11) is exposed to radiation from a light source (5) through the interposed optical plate (9) so as to locally fluidify said conductive fluid (13) so that the latter flows through perforations (21) produced in the bottom wall (19) of the holding structure (11) and deposits in a preset pattern.
